# EUROPÄISCHE PATENTSCHRIFT

(11) **EP 3 698 195 B1**
(45) Veröffentlichungstag und Bekanntmachung des Hinweises auf die Patenterteilung: **08.03.2023**
(21) Anmeldenummer: 18795335.1
(22) Anmeldetag: 18.10.2018
(51) Int. Cl.: G02B 26/08, B81B 3/00, G02B 26/10, G01S 7/481

(54) **MIKROMECHANISCHE MIKROSPIEGELANORDNUNG**
MICROMECHANICAL MICROMIRROR ARRAY
AGENCEMENT MICROMÉCANIQUE DE MICROMIROIR

(30) Priorität: 19.10.2017 DE 102017218670
(43) Veröffentlichungstag der Anmeldung: 26.08.2020
(73) Patentinhaber: Robert Bosch GmbH, 70442 Stuttgart (DE)
(72) Erfinder: MUCHOW, Joerg, 81477 Muenchen (DE); GRUTZECK, Helmut, 72127 Kusterdingen (DE); SCHARY, Timo, 72631 Aichtal-Neuenhaus (DE); KAUPMANN, Philip, 79194 Gundelfingen (DE)
(86) Internationale Anmeldenummer: PCT/EP2018/078609
(87) Internationale Veröffentlichungsnummer: WO 2019/077063

(56) Entgegenhaltungen:
- EP-A1- 3 086 548
- US-B1- 6 198 565
- TAKAYUKI ISEKI ET AL: "Shrinking design of a MEMS optical scanner having four torsion beams and arms", SENSORS AND ACTUATORS A: PHYSICAL, Bd. 164, Nr. 1-2, 1. November 2010 (2010-11-01), Seiten 95-106, XP055539857, NL ISSN: 0924-4247, DOI: 10.1016/j.sna.2010.09.007 in der Anmeldung erwähnt

## Beschreibung

Die Erfindung betrifft eine mikromechanische Mikrospiegelanordnung.

### Stand der Technik

Obwohl auch beliebige mikromechanische Bauelemente anwendbar sind, werden die vorliegende Erfindung und die ihr zugrundeliegende Problematik anhand von mikromechanischen Mikrospiegelanordnungen für Kraftfahrzeuge erläutert.

Mikrospiegelanordnungen mit Piezoantrieben sind im Stand der Technik bekannt und werden beispielsweise in Kraftfahrzeug-Scheinwerfern oder LIDAR-Systemen eingesetzt. Dabei ist es wünschenswert, mit einer kompakten Bauform einen möglichst großen Bereich durch Ablenkung des Mikrospiegels zu scannen. Die verwendeten Piezoantriebe nutzen die Wirkung des Piezoeffekts. Sobald an eine piezoelektrische Schicht eine Spannung angelegt wird, verformt sie sich.

Aus Sensors and Actuators A 164 (2010) Seite 95-106, T. Iseki et al. ist eine mikromechanische Mikrospiegelanordnung mit vier Torsionsbalken und -armen bekannt, welche über einen Piezoantrieb deformierbar sind und welche dadurch einen angekoppelten Mikrospiegel auslenken.

Aus den Dokumenten EP 3 086 548 A1 und US 6 198 565 B1 sind mikromechanische Mikrospiegelanordnungen bekannt, die zumindest Teile des Oberbegriffs von Anspruch 1 enthalten.

### Offenbarung der Erfindung

Die Erfindung schafft eine mikromechanische Mikrospiegelanordnung nach Anspruch 1.

Bevorzugte Weiterbildungen sind Gegenstand der Unteransprüche.

### Vorteile der Erfindung

Kern der Erfindung ist die Erstreckung der ersten und zweiten Schwenkflügeleinrichtung entlang der Richtung der dritten Achse über die zweite Achse als Drehachse hinaus. Hierdurch lässt sich ein Hebeleffekt erzielen, der zu größeren Drehungen der Mikrospiegeleinrichtung bei relativ kleinen Auslenkungen der ersten und zweiten Schwenkflügeleinrichtung führt.

Gemäß einer nicht beanspruchten Weiterbildung ist die erste Schwenkflügeleinrichtung in einem ersten Bereich des Rahmens in der ersten Ebene aufgehängt, erstreckt sich entlang der Richtung der dritten Achse über die zweite Achse hinaus und ist an ihrem Ende über die erste Federeinrichtung mit einem ersten Fortsatz der Mikrospiegeleinrichtung verbunden, wobei die zweite Schwenkflügeleinrichtung in einem zweiten Bereich des Rahmens, der dem ersten Bereich gegenüberliegt, in der ersten Ebene aufgehängt ist, sich entlang der Richtung der dritten Achse über die zweite Achse hinaus erstreckt und an ihrem Ende über die zweite Federeinrichtung mit einem zweiten Fortsatz der Mikrospiegeleinrichtung verbunden ist, wobei der erste Fortsatz und der zweite Fortsatz in dieselbe Richtung entlang der dritten Achse bezüglich der zweiten Achse versetzt sind. So lässt sich eine symmetrische Auslenkung der Mikrospiegeleinrichtung realisieren.

Erfindungsgemäß verläuft der erste Fortsatz geradlinig und der zweite Fortsatz gewinkelt. So lassen sich die die erste und zweite Schwenkflügeleinrichtung entlang der dritten Achse platzsparend verschachteln.

Erfindungsgemäß ist die erste Schwenkflügeleinrichtung in einem ersten Bereich des Rahmens in der ersten Ebene aufgehängt, erstreckt sich gewinkelt entlang der Richtung der zweiten Achse und der dritten Achse, erstreckt sich entlang der Richtung der dritten Achse über die zweite Achse hinaus und ist an ihrem Ende über die erste Federeinrichtung mit einem ersten Fortsatz der Mikrospiegeleinrichtung verbunden, wobei die zweite Schwenkflügeleinrichtung in einem zweiten Bereich des Rahmens, der seitlich zum ersten Bereich versetzt ist, in der ersten Ebene aufgehängt ist, sich gewinkelt entlang der Richtung der zweiten Achse und der dritten Achse erstreckt, sich entlang der Richtung der dritten Achse über die zweite Achse hinaus erstreckt und an ihrem Ende über die zweite Federeinrichtung mit einem zweiten Fortsatz der Mikrospiegeleinrichtung verbunden ist, wobei der erste Fortsatz und der zweite Fortsatz in dieselbe Richtung entlang der dritten Achse bezüglich der zweiten Achse versetzt sind, und wobei die Mikrospiegeleinrichtung auf einer der der ersten Seite gegenüberliegenden zweiten Seite über einen Torsionsbalken am Rahmen aufgehängt ist. So lassen sich besonders große Verdrehungen der Mikrospiegeleinrichtung über die Länge der ersten und zweiten Schwenkflügeleinrichtung erzielen.

Gemäß einer weiteren bevorzugten Weiterbildung sind eine erste Torsionseinrichtung zum Verdrehen der ersten Schwenkflügeleinrichtung um die zweite Achse im ersten Bereich zwischen dem ersten Bereich des Rahmens und der ersten Schwenkflügeleinrichtung in der ersten Ebene aufgehängt und eine zweite Torsionseinrichtung zum Verdrehen der zweiten Schwenkflügeleinrichtung um die zweite Achse im zweiten Bereich zwischen dem zweiten Bereich des Rahmens und der ersten Schwenkflügeleinrichtung in der ersten Ebene aufgehängt. So lässt sich die Verdrehung der Mikrospiegeleinrichtung durch eine Torsion weiter steigern.

Gemäß einer nicht beanspruchten Weiterbildung sind die erste Schwenkflügeleinrichtung und die zweite Schwenkflügeleinrichtung jeweils auf einer ersten Seite der Mikrospiegeleinrichtung und einer gegenüberliegenden zweiten Seite der Mikrospiegeleinrichtung angekoppelt. Dies ermöglicht eine besonders robuste symmetrische Ankopplung.

Gemäß einer nicht beanspruchten Weiterbildung umgreifen die erste Schwenkflügeleinrichtung und die zweite Schwenkflügeleinrichtung die Mikrospiegeleinrichtung jeweils gabelförmig, wobei die erste Schwenkflügeleinrichtung über eine fünfte Federeinrichtung am Rahmen in der ersten Ebene aufgehängt ist, sich entlang der Richtung der dritten Achse beidseitig der Mikrospiegeleinrichtung über die zweite Achse hinaus erstreckt und an ihren Enden über die erste Federeinrichtung mit der Mikrospiegeleinrichtung verbunden ist, und wobei die zweite Schwenkflügeleinrichtung über eine sechste Federeinrichtung am Rahmen in der ersten Ebene aufgehängt ist, sich entlang der Richtung der dritten Achse beidseitig der Mikrospiegeleinrichtung über die zweite Achse hinaus erstreckt und an ihren Enden über die sechste Federeinrichtung mit der Mikrospiegeleinrichtung verbunden ist. So lassen sich die erste und zweite Schwenkflügeleinrichtung quasi schwebend aufhängen.

Gemäß einer nicht beanspruchten Weiterbildung ist die mikromechanische Mikrospiegelanordnung ausgestattet mit einer am Rahmen aufgehängten, in den Bereich der Aussparung hineinragenden dritten Schwenkflügeleinrichtung, welche an der Mikrospiegeleinrichtung über eine dritte Federeinrichtung angekoppelt ist, einer am Rahmen aufgehängten, in den Bereich der Aussparung hineinragenden vierten Schwenkflügeleinrichtung, welche an der Mikrospiegeleinrichtung über eine vierte Federeinrichtung angekoppelt ist, einer dritten Antriebseinrichtung zum Auslenken der dritten Schwenkflügeleinrichtung entlang einer ersten Achse, welche senkrecht zur ersten Ebene angeordnet ist, und einer vierten Antriebseinrichtung zum gegenphasigen Auslenken der vierten Schwenkflügeleinrichtung entlang der ersten Achse, wobei die Mikrospiegeleinrichtung durch das gegenphasige Auslenken der dritten Schwenkflügeleinrichtung und der vierten Schwenkflügeleinrichtung um die zweite Achse elastisch aus der ersten Ebene heraus drehbar ist, und wobei die dritte Schwenkflügeleinrichtung und die vierte Schwenkflügeleinrichtung derart gestaltet sind, dass sie sich auf einer zweiten Seite der Mikrospiegeleinrichtung, welche der ersten Seite gegenüberliegt, entlang der Richtung der im Wesentlichen senkrecht zur zweiten Achse angeordneten dritten Achse über die zweite Achse hinaus erstrecken. So lässt sich ein Vierfachantrieb realisieren.

Gemäß einer weiteren bevorzugten nicht beanspruchten Weiterbildung sind die dritte Schwenkflügeleinrichtung und die vierte Schwenkflügeleinrichtung, dritte Federeinrichtung, vierte Federeinrichtung, dritte Antriebseinrichtung und vierte Antriebseinrichtung auf einer der ersten Seite gegenüberliegenden zweiten Seite der Mikrospiegeleinrichtung symmetrisch zur ersten Seite angeordnet und angekoppelt. So lässt sich ein symmetrischer Vierfachantrieb realisieren.

Gemäß einer weiteren bevorzugten Weiterbildung weist die erste Antriebseinrichtung und/oder die zweite Antriebseinrichtung eine piezoelektrische Antriebseinrichtung auf, wobei eine piezoelektrische Leiterbahneinrichtung auf der ersten Schwenkflügeleinrichtung bzw. der zweiten Schwenkflügeleinrichtung aufgebracht ist. Dies ist ein robuster, leicht herstellbarer Antrieb.

Gemäß einer weiteren bevorzugten Weiterbildung weist die erste Antriebseinrichtung und/oder die zweite Antriebseinrichtung eine elektromagnetische Antriebseinrichtung auf, welche eine externe Magnetfelderzeugungseinrichtung und eine Spuleneinrichtung aufweist, wobei die Spuleneinrichtung auf der ersten Schwenkflügeleinrichtung bzw. der zweiten Schwenkflügeleinrichtung und dem Rahmen aufgebracht ist. So lässt sich ein elektromagnetischer Antrieb platzsparend gestalten.

Gemäß einer weiteren bevorzugten Weiterbildung ist eine Sensoreinrichtung mit einer Mehrzahl von auf jeweiligen Federn aufgebrachten Piezowiderständen, welche zwischen dem Rahmen und der ersten Schwenkflügeleinrichtung und dem Rahmen und der zweiten Schwenkflügeleinrichtung angebracht sind, zum Erfassen des elastischen Herausdrehens der Mikrospiegeleinrichtung um die zweite Achse aus der ersten Ebene vorgesehen. So lässt sich eine Sensoreinrichtung platzsparend integrieren.

Gemäß einer weiteren bevorzugten Weiterbildung ist auf einer Rückseite des Rahmens ein erstes Kappensubstrat mit einer im Bereich der Mikrospiegeleinrichtung vorgesehenen Aussparung und auf der Vorderseite des Rahmens ein zweites Kappensubstrat mit einem im Bereich der Mikrospiegeleinrichtung vorgesehenen optischen Fenster angeordnet. So lässt sich eine Schutzverpackung auf Waferebene herstellen.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1a)-e): eine mikromechanische Mikrospiegelanordnung gemäß einer ersten nicht beanspruchtenAusführungsform;
- Fig. 2: die mikromechanische Mikrospiegelanordnung gemäß der ersten Ausführungsform der vorliegenden Erfindung mit einer Verkappung;
- Fig. 3: eine mikromechanische Mikrospiegelanordnung gemäß einer zweiten Ausführungsform der vorliegenden Erfindung;
- Fig. 4: eine mikromechanische Mikrospiegelanordnung gemäß einer dritten Ausführungsform der vorliegenden Erfindung;
- Fig. 5: eine mikromechanische Mikrospiegelanordnung gemäß einer vierten nicht beanspruchten Ausführungsform;
- Fig. 6a)-c): detaillierte Darstellungen der Sensoreinrichtung der vierten nicht beanspruchten Ausführungsform; und
- Fig. 7: eine mikromechanische Mikrospiegelanordnung gemäß einer fünften nicht beanspruchten Ausführungsform.

### Ausführungsformen der Erfindung

In den Figuren bezeichnen gleiche Bezugszeichen gleiche bzw. funktionsgleiche Elemente.

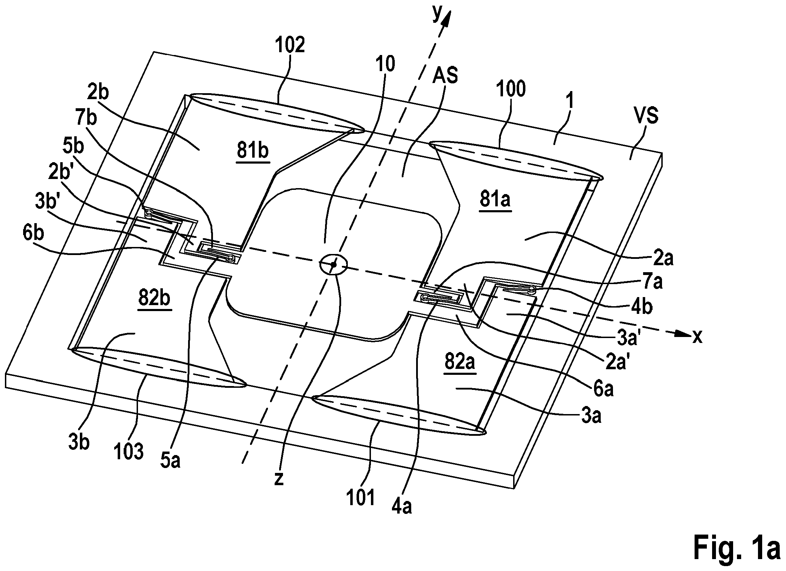

Fig. 1a)-e) zeigen eine mikromechanische Mikrospiegelanordnung gemäß einer ersten nicht beanspruchten Ausführungsform.

Durch die Achsen x, y und z wird ein bei dieser Ausführungsform orthogonales Koordinatensystem gebildet, welcher allerdings im allgemeinen Fall auch von der Orthogonalform abweichen kann.

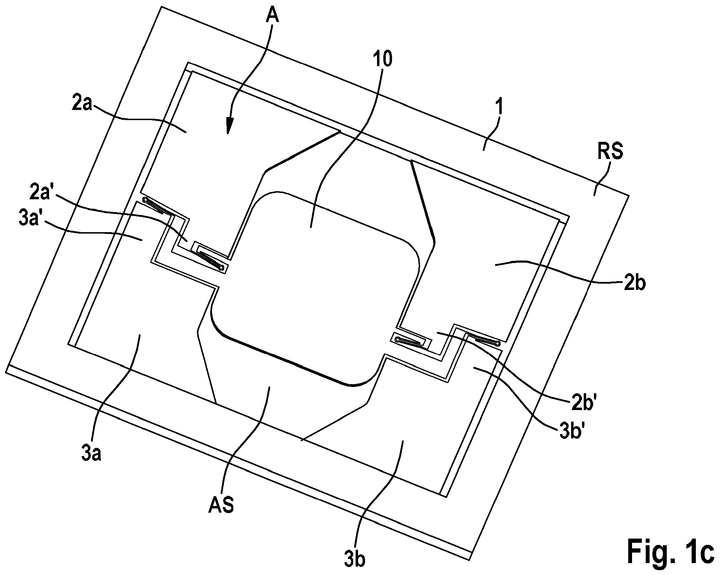

In Fig. 1a)-1e) bezeichnet Bezugszeichen 1 einen Rahmen der mikromechanischen Mikrospiegelanordnung, welche beispielsweise aus Silizium durch entsprechende Strukturierungsprozesse hergestellt ist. Dabei ist VS die Vorderseite des Rahmens 1 und RS die Rückseite des Rahmens 1 (siehe Fig. 1c).

Der Rahmen 1 weist eine Aussparung AS auf, in der eine Mikrospiegeleinrichtung 10 am Rahmen 1 in der xy-Ebene aufgehängt ist.

Eine erste im Bereich 100 am Rahmen 1 aufgehängte, in den Bereich der Aussparung AS hineinragende Schwenkflügeleinrichtung 2a erstreckt sich ebenfalls im Ruhezustand in der xy-Ebene und ist über eine erste Federeinrichtung 4a mit einem ersten linearen Fortsatz 7a der Mikrospiegeleinrichtung 10 verbunden. Dabei weist die erste Schwenkflügeleinrichtung 2a einen Bereich 2a' auf, welcher sich entlang der y-Achse an einer ersten Seite der Mikrospiegeleinrichtung 10 über die y-Achse hinaus erstreckt. Der erste lineare Fortsatz 7a der Mikrospiegeleinrichtung 10 ist entsprechend entlang der y-Achse versetzt zur x-Achse an die Mikrospiegeleinrichtung 10 angesetzt. Aufgebracht auf die erste Schwenkflügeleinrichtung 2a an der Vorderseite VS ist eine erste piezoelektrische Antriebseinrichtung 81a, mittels der die erste Schwenkflügeleinrichtung 2a entlang der z-Achse aus der xy-Ebene heraus auslenkbar ist.

Eine zweite im Bereich 101 gegenüberliegend am Rahmen 1 aufgehängte, in den Bereich der Aussparung AS hineinragende Schwenkflügeleinrichtung 3a erstreckt sich ebenfalls im Ruhezustand in der xy-Ebene und ist über eine zweite Federeinrichtung 4b mit einem ersten gewinkelten Fortsatz 6a der Mikrospiegeleinrichtung 10 verbunden. Dabei weist die zweite Schwenkflügeleinrichtung 3a einen Bereich 3a' auf, welcher sich entlang der y-Achse an der ersten Seite der Mikrospiegeleinrichtung 10 über die y-Achse hinaus erstreckt, und zwar in entgegengesetzter Richtung wie der Bereich 2a'.

Die zweite Schwenkflügeleinrichtung 3a ist bezüglich der x-Achse achsensymmetrisch zur ersten Schwenkflügeleinrichtung 2a ausgestaltet. Der erste gewinkelte Fortsatz 6a der Mikrospiegeleinrichtung 10 ist entlang der y- Achse in dieselbe Richtung weiter versetzt zur x-Achse als der erste lineare Fortsatz 7a an die Mikrospiegeleinrichtung 10 angesetzt. Aufgebracht auf die zweite Schwenkflügeleinrichtung 3a an der Vorderseite VS ist eine zweite piezoelektrische Antriebseinrichtung 82a, mittels der die zweite Schwenkflügeleinrichtung 3a entlang der z-Achse aus der xy-Ebene heraus auslenkbar ist.

Eine dritte im Bereich 102 am Rahmen 1 aufgehängte, in den Bereich der Aussparung AS hineinragende Schwenkflügeleinrichtung 2b erstreckt sich ebenfalls im Ruhezustand in der xy-Ebene und ist über eine dritte Federeinrichtung 5a mit einem zweiten linearen Fortsatz 7 der Mikrospiegeleinrichtung 10 verbunden. Dabei weist die dritte Schwenkflügeleinrichtung 2b einen Bereich 2b' auf, welcher sich entlang der y-Achse an einer zweiten Seite der Mikrospiegeleinrichtung 10 über die y-Achse hinaus erstreckt, wobei die zweite Seite der ersten Seite gegenüberliegt. Die dritte Schwenkflügeleinrichtung 2b ist bezüglich der y-Achse achsensymmetrisch zur ersten Schwenkflügeleinrichtung 2a ausgestaltet. Der zweite lineare Fortsatz 7b der Mikrospiegeleinrichtung 10 ist entsprechend entlang der y-Achse versetzt zur x-Achse an die Mikrospiegeleinrichtung 10 angesetzt. Aufgebracht auf die dritte Schwenkflügeleinrichtung 2b an der Vorderseite VS ist eine dritte piezoelektrische Antriebseinrichtung 81b, mittels der die dritte Schwenkflügeleinrichtung 2b entlang der z-Achse aus der xy-Ebene heraus auslenkbar ist.

Eine vierte im Bereich 101 gegenüberliegend am Rahmen 1 aufgehängte, in den Bereich der Aussparung AS hineinragende Schwenkflügeleinrichtung 3b erstreckt sich ebenfalls im Ruhezustand in der xy-Ebene und ist über eine vierte Federeinrichtung 5b mit einem zweiten gewinkelten Fortsatz 6b der Mikrospiegeleinrichtung 10 verbunden. Dabei weist die vierte Schwenkflügeleinrichtung 3b einen Bereich 3b' auf, welcher sich entlang der y-Achse an der zweiten Seite der Mikrospiegeleinrichtung 10 über die y-Achse hinaus erstreckt, und zwar in entgegengesetzter Richtung wie der Bereich 2b'.

Die vierte Schwenkflügeleinrichtung 3b ist bezüglich der x-Achse achsensymmetrisch zur dritten Schwenkflügeleinrichtung 2b ausgestaltet. Der zweite gewinkelte Fortsatz 6b der Mikrospiegeleinrichtung 10 ist entlang der y- Achse in dieselbe Richtung weiter versetzt zur x-Achse als der zweite lineare Fortsatz 7b an die Mikrospiegeleinrichtung 10 angesetzt. Aufgebracht auf die vierte Schwenkflügeleinrichtung 3b an der Vorderseite VS ist eine vierte piezoelektrische Antriebseinrichtung 82b, mittels der die vierte Schwenkflügeleinrichtung 3b entlang der z-Achse aus der xy-Ebene heraus auslenkbar ist.

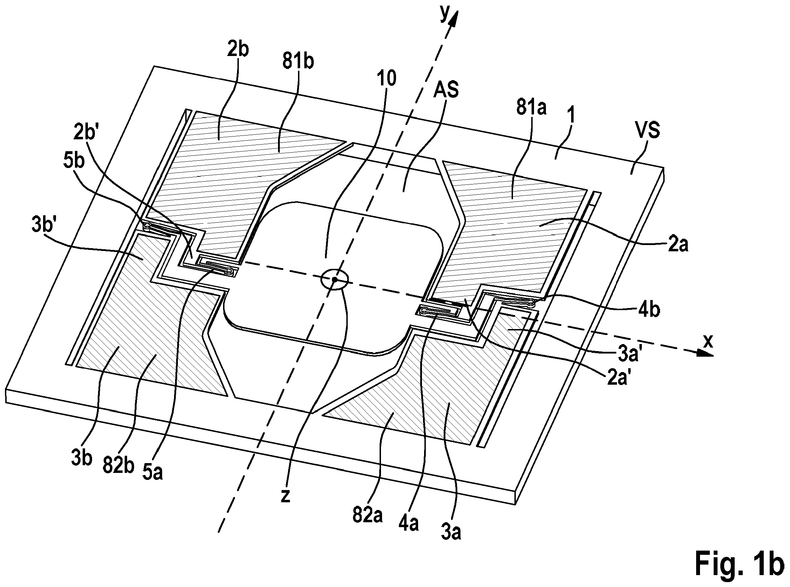

Wie in Fig. 1b) durch die Schraffuren der ersten und dritten piezoelektrischen Antriebseinrichtung 81a, 81b dargestellt, werden die erste Schwenkflügeleinrichtung 2a und die dritte Schwenkflügeleinrichtung 2b durch die erste und dritte piezoelektrische Antriebseinrichtung 81a bzw. 81b gleichphasig entlang der z-Achse ausgelenkt.

Wie in Fig. 1b) durch die Schraffuren der zweiten und vierten piezoelektrischen Antriebseinrichtung 82a, 82b dargestellt, werden die zweite Schwenkflügeleinrichtung 3a und die vierte Schwenkflügeleinrichtung 3b werden mittels der zweiten piezoelektrischen Antriebseinrichtung 82a und der vierten piezoelektrischen Antriebseinrichtung 82b ebenfalls gleichphasig entlang der z-Achse ausgelenkt. Dabei werden die erste und dritte Schwenkflügeleinrichtung 2a, 2b im Vergleich zur zweiten und vierten Schwenkflügeleinrichtung 3a, 3b gegenphasig entlang der z-Achse ausgelenkt.

Durch das gegenphasige Auslenken der ersten und dritten Schwenkflügeleinrichtung 2a, 2b und der zweiten und vierten Schwenkflügeleinrichtung 3a, 3b ist die Mikrospiegeleinrichtung 10 um die x-Achse als Drehachse elastisch aus der xy-Ebene heraus drehbar.

Mit Bezug auf Fig. 1c) ist ersichtlich, dass die Mikrospiegeleinrichtung 10 und die erste bis vierte Schwenkflügeleinrichtung 2a, 3a, 2b, 3b sowie die Fortsätze 7a, 7b, 6a, 6b und die Federn 4a, 4b, 5a, 5b eine geringere Dicke aufweisen als der sie umgebende Rahmen 1. Dies kann prozesstechnisch beispielsweise durch Herausätzen einer Kaverne A an der Rückseite RS des Rahmens 1 bewerkstelligt werden.

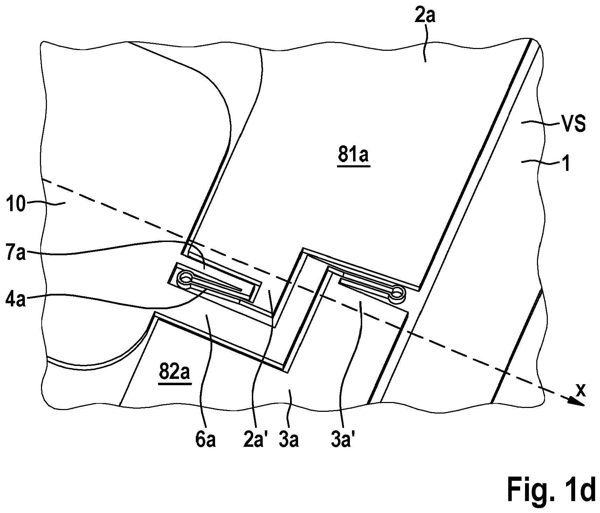

Fig. 1d) zeigt eine vergrößerte Darstellung der Ankopplung der der ersten und zweiten Schwenkflügeleinrichtung 2a, 3a über die Federn 4a, 4b an die Fortsätze 7a, 6a der Mikrospiegeleinrichtung 10.

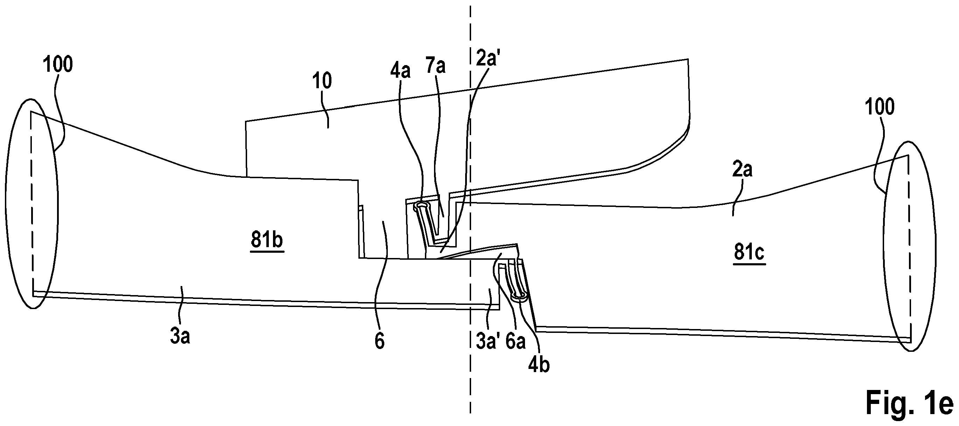

Fig. 1e) zeigt den ausgelenkten Zustand der ersten Schwenkflügeleinrichtung 2a und der zweiten Schwenkflügeleinrichtung 3a in entgegengesetzte Richtungen entlang der z-Achse, wodurch die Mikrospiegeleinrichtung 10 verdreht ist.

Aufgrund der Tatsache, dass die erste bis vierte Schwenkflügeleinrichtung 2a, 3a, 2b, 3b, entlang der y-Achse über die x-Achse als Drehachse verlängert sind, lassen sich mit relativ kleinen Deformierungen der Schwenkflügeleinrichtungen 2a, 3a, 2b, 3b relativ große Auslenkungen der Mikrospiegeleinrichtung 10 erzielen.

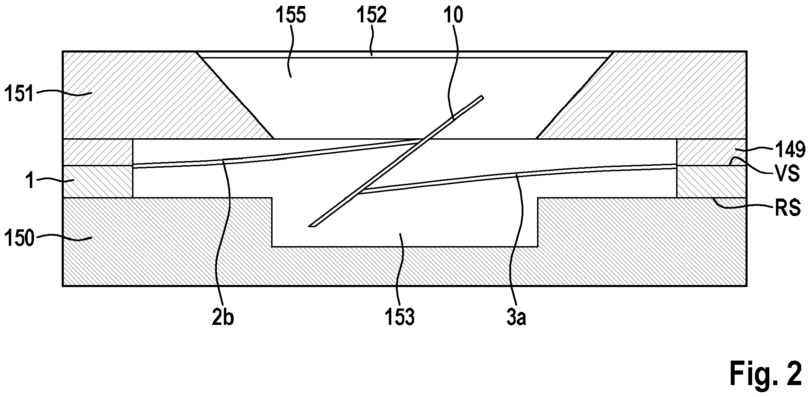

Fig. 2 zeigt die mikromechanische Mikrospiegelanordnung gemäß der ersten Ausführungsform mit einer Verkappung.

Gemäß Fig. 2 ist auf der Rückseite RS des Rahmens 1 ein erstes Kappensubstrat 150 mit einer im Bereich der Mikrospiegeleinrichtung 10 vorgesehenen Aussparung 153 vorgesehen. Die Mikrospiegeleinrichtung 10 kann somit in die Aussparung 153 hinein ausgelenkt werden.

Auf der Vorderseite VS des Rahmens 1 sind ein ringförmiges Zwischensubstrat 149 und ein darauf befindliches zweites Kappensubstrat 151 vorgesehen, wobei das zweite Kappensubstrat 151 im Bereich der Mikrospiegeleinrichtung 10 ein optisches Fenster 152 aufweist. Das optische Fenster 152 ist oberhalb einer Durchgangsöffnung 155 des zweiten Kappensubstrats 151 angeordnet, wobei die Mikrospiegeleinrichtung 10 beim Auslenken ebenfalls in die Durchgangsöffnung 155 hinein bewegt werden kann.

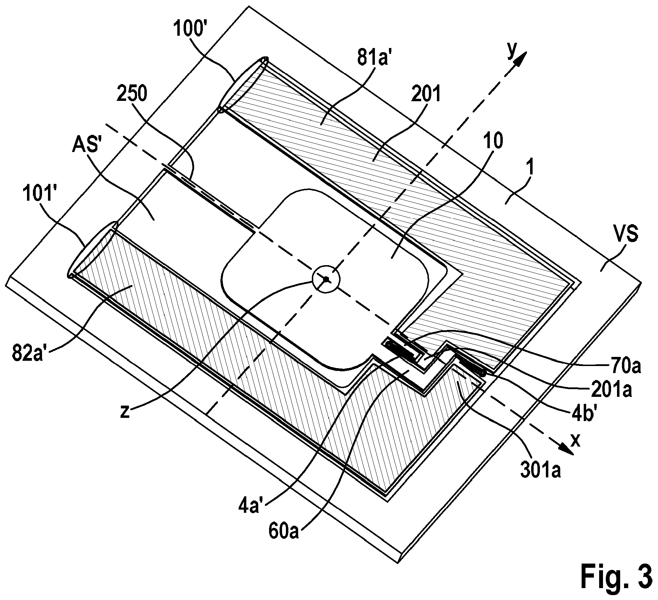

Fig. 3 zeigt eine mikromechanische Mikrospiegelanordnung gemäß einer zweiten Ausführungsform der vorliegenden Erfindung.

Bei der zweiten Ausführungsform trägt die erste Schwenkflügeleinrichtung Bezugszeichen 201 und ist im Bereich 100' an den Rahmen 1 angekoppelt. Auf der ersten Schwenkflügeleinrichtung 201 an der Vorderseite VS ist eine erste piezoelektrische Antriebseinrichtung 81a' vorgesehen.

Die zweite Schwenkflügeleinrichtung trägt Bezugszeichen 301 und weist der Vorderseite VS aufgebrachte zweite piezoelektrische Antriebseinrichtung 82a' auf. Die zweite Schwenkflügeleinrichtung 301 ist im Bereich 101' an den Rahmen 1 angekoppelt.

Die erste Schwenkflügeleinrichtung 201 und die zweite Schwenkflügeleinrichtung 301 sind achsensymmetrisch zur x-Achse ausgestaltet und ragen parallel in die Aussparung AS' hinein.

Die erste Schwenkflügeleinrichtung 201 erstreckt sich winkelförmig entlang der x-Achse und der y-Achse, wobei die Erstreckung entlang der y-Achse ebenfalls wie bei der ersten Ausführungsform im Bereich 201a über die x-Achse als Drehachse hinausgeführt ist. An ihrem Ende ist die erste Schwenkflügeleinrichtung 201 auf einer ersten Seite über eine erste Federeinrichtung 4a' mit einem ersten linearen Fortsatz 70a der Mikrospiegeleinrichtung 10 verbunden, wobei der erste lineare Fortsatz 70a wie bei ersten Ausführungsform entlang der y-Achse zur x-Achse versetzt ist.

Die zweite Schwenkflügeleinrichtung 301 ist wie die erste Schwenkflügeleinrichtung 201 ebenfalls in der xy-Ebene aufgehängt und erstreckt sich gewinkelt entlang der x-Achse und der y-Achse, wobei die Erstreckung entlang der y-Achse im Bereich 301a über die x-Achse als Drehachse hinausgeht. An ihrem Ende ist die zweite Schwenkflügeleinrichtung 301 über eine zweite Federeinrichtung 4b' mit einem ersten gewinkelten Fortsatz 60a der Mikrospiegeleinrichtung 10 verbunden. Sowohl der erste Fortsatz 70a als auch der zweite Fortsatz 60a sind in dieselbe Richtung entlang der y-Achse bezüglich der x-Achse versetzt, wobei der gewinkelte Fortsatz 60a weiter als der lineare Fortsatz 70a zur x-Achse versetzt ist.

Somit ist die Ankopplung der ersten und zweiten Schwenkflügeleinrichtung 201, 301 an die Mikrospiegeleinrichtung analog wie bei der ersten Ausführungsform und lediglich die Erstreckung der ersten und zweiten Schwenkflügeleinrichtung 201, 301 unterschiedlich.

Auf einer zweiten Seite, welche der ersten Seite gegenüberliegt, ist die Mikrospiegeleinrichtung 10 über einen Torsionsbalken 250 am Rahmen 1 aufgehängt, wobei der Torsionsbalken 250 entlang der x-Achse verläuft.

Wie durch entsprechende Schraffuren angedeutet, sind die erste Schwenkflügeleinrichtung 201 und die zweite Schwenkflügeleinrichtung 301 durch die erste und zweite piezoelektrische Antriebseinrichtung 81a', 82a' ebenfalls gegenphasig entlang der z-Achse auslenkbar, wodurch eine Drehbarkeit der Mikrospiegeleinrichtung 10 um die x-Achse erzielbar ist.

Der Torsionsbalken 250 dient als einfaches Drehgelenk und kann ggf. auch mehrfach gefaltet sein, um die Torsionssteifigkeit zu verringern. Bei der zweiten Ausführungsform lassen sich die erste Schwenkflügeleinrichtung 201 und die zweite Schwenkflügeleinrichtung 301 im Vergleich zur ersten Ausführungsform länger gestalten und damit stärker auslenken.

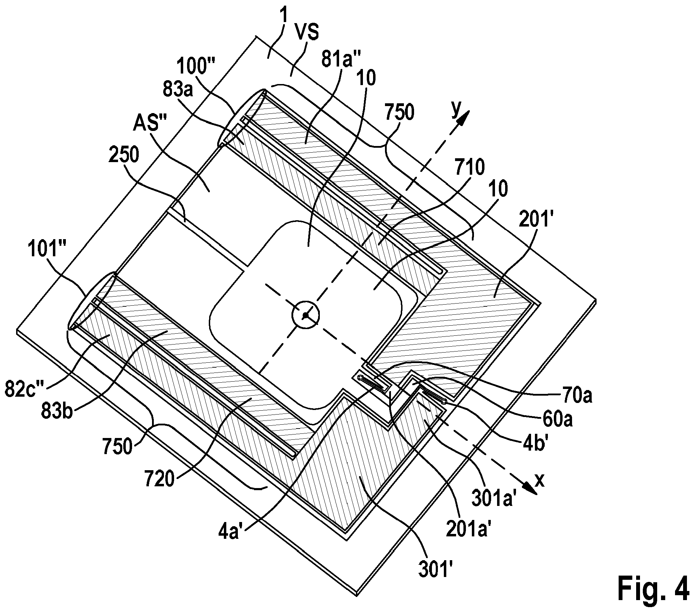

Fig. 4 zeigt eine mikromechanische Mikrospiegelanordnung gemäß einer dritten Ausführungsform der vorliegenden Erfindung.

Bei der dritten Ausführungsform trägt die erste Schwenkflügeleinrichtung Bezugszeichen 201' und die zweite Schwenkflügeleinrichtung Bezugszeichen 301', wobei die über die x-Achse verlängerten Bereiche mit Bezugszeichen 201a' bzw. 301a' bezeichnet sind. Die Bereiche 100" und 101" bezeichnen die Ankopplungsbereiche der ersten Schwenkflügeleinrichtung 201' bzw. der zweiten Schwenkflügeleinrichtung Bezugszeichen 301' am Rahmen 10.

Die erste piezoelektrische Antriebseinrichtung 81a" ist an der Vorderseite VS auf der ersten Schwenkflügeleinrichtung 201' aufgebracht, und die zweite piezoelektrische Antriebseinrichtung 82a" ist an der Vorderseite VS auf der zweiten Schwenkflügeleinrichtung 301 aufgebracht. Die Ankopplung an die Mikrospiegeleinrichtung 10 und die Erstreckung der ersten Schwenkflügeleinrichtung 201' und der zweiten Schwenkflügeleinrichtung 301' in der Aussparung AS" ist analog zur zweiten Ausführungsform.

Zusätzlich zur zweiten Ausführungsform sind neben der ersten Schwenkflügeleinrichtung 201' und beabstandet davon eine erste Torsionseinrichtung 710 mit einer ersten darauf aufgebrachten dritten piezoelektrischen Antriebseinrichtung 83a und neben der zweiten Schwenkflügeleinrichtung 301' und beabstandet davon eine zweite Torsionseinrichtung 720 mit einer darauf aufgebrachten vierten piezoelektrischen Antriebseinrichtung 83b vorgesehen.

Werden an die dritte und vierte piezoelektrische Antriebseinrichtung 83a, 83b der ersten Torsionseinrichtung 710 bzw. der zweiten Torsionseinrichtung 720 entgegengesetzte Polarisationen wie an die erste und zweite piezoelektrische Antriebseinrichtung 81a", 82a" der ersten Schwenkflügeleinrichtung 201' bzw. zweiten Schwenkflügeleinrichtung 301' angelegt, so bewirken sie durch eine Kontraktion im Bereich 750 und damit eine zusätzliche Verdrehung und damit eine weitere Auslenkung der ersten und zweiten Schwenkflügeleinrichtung 201', 301' entlang der z-Achse und damit eine stärkere Verdrehung der Mikrospiegeleinrichtung um die x-Achse.

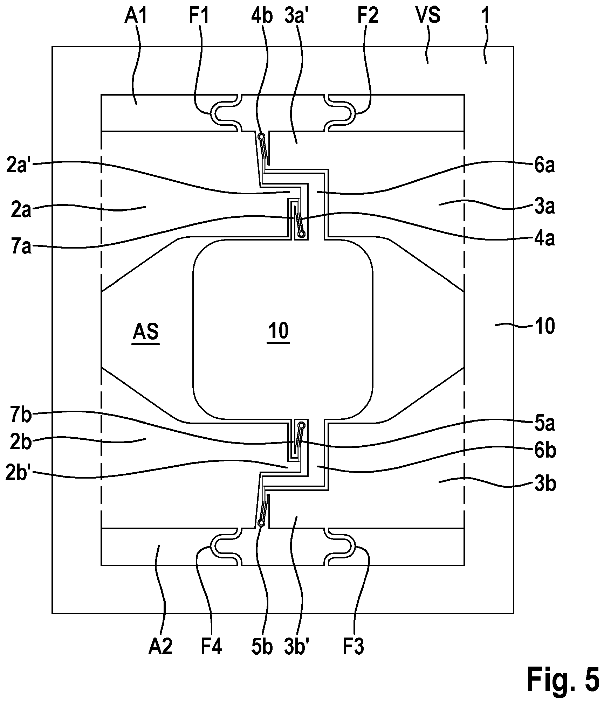

Fig. 5 zeigt eine mikromechanische Mikrospiegelanordnung gemäß einer vierten Ausführungsform.

Bei der vierten Ausführungsform gemäß Fig. 5 ist der allgemeine Aufbau analog zur ersten Ausführungsform.

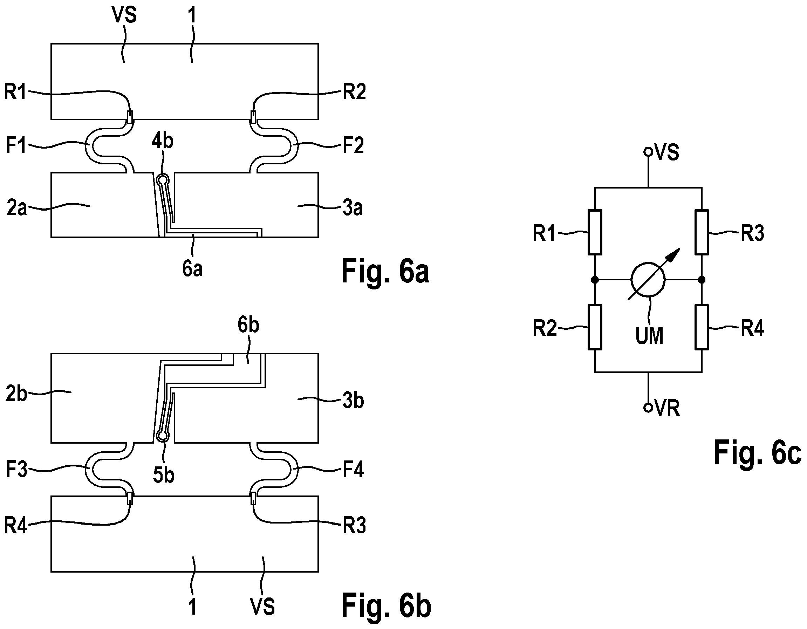

Zusätzlich vorgesehen neben der ersten und zweiten Schwenkflügeleinrichtung 2a, 3a und der dritten und vierten Schwenkflügeleinrichtung 2b, 3b sind eine jeweilige weitere Aussparung A1 bzw. A2, innerhalb derer Federn F1, F2 bzw. F3, F4 eingespannt sind. Über die Federn F1, F2 bzw. F3, F4 und eine darauf aufgebrachte Piezowiderstandseinrichtung R1-R4 (vgl. Fig. 6a)-c)) lassen sich die Auslenkungen der Schwenkflügeleinrichtungen 2a, 3a, bzw. 2b, 3b detektieren und somit die Auslenkung der Mikrospiegeleinrichtung 10 um die x-Achse aus der xy-Ebene, wie nachstehend mit Bezug auf Fig. 6a)-6c) erläutert wird.

Fig. 6a)-c) sind detaillierte Darstellungen der Sensoreinrichtung der vierten Ausführungsform der vorliegenden Erfindung.

Wie in Fig. 6a)-6c) gezeigt, sind jeweilige piezoresistive Widerstände R1, R2, R3, R4 auf den Federn F1-F4 in ihren Endbereichen am Rahmen 1 aufgebracht.

Mittels einer nicht dargestellten Leiterbahneinrichtung lassen sich die Piezowiderstände R1-R4 zu einer Wheatstone-Messbrücke verschalten, an die externe Potenziale VS, VR angelegt werden können und die Brückenspannung mittels einer Spannungserfassungseinrichtung UM abgegriffen werden kann, wie in Fig. 6c) schematisch dargestellt.

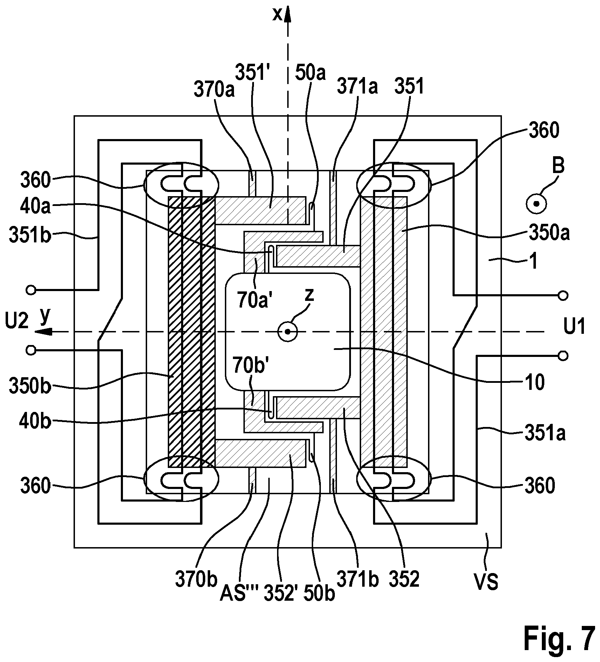

Fig. 7 zeigt eine mikromechanische Mikrospiegelanordnung gemäß einer fünften Ausführungsform der vorliegenden Erfindung.

Bei der fünften Ausführungsform bezeichnet Bezugszeichen 350a eine erste Schwenkflügeleinrichtung und Bezugszeichen 350b eine zweite Schwenkflügeleinrichtung, welche in die Aussparung AS‴ hineinragen.

Die erste Schwenkflügeleinrichtung 350a und die zweite Schwenkflügeleinrichtung 350b sind jeweils auf einer ersten Seite der Mikrospiegeleinrichtung 10 und einer gegenüberliegenden zweiten Seite der Mikrospiegeleinrichtung 10 gabelförmig an die Mikrospiegeleinrichtung 10 angekoppelt. Dabei sind mit Bezugszeichen 351, 352 gabelzinkenförmige Verlängerungsbereiche der ersten Schwenkflügeleinrichtung 350a und mit Bezugszeichen 351', 352' gabelzinkenförmige Verlängerungsbereiche der zweiten Schwenkflügeleinrichtung 350b bezeichnet.

Die erste Schwenkflügeleinrichtung 350a ist über eine Federeinrichtung 371a, 371b an gegenüberliegenden Seiten am Rahmen 1 in der y-Ebene aufgehängt, erstreckt sich entlang der y-Achse beidseitig der Mikrospiegeleinrichtung 10 über die x-Achse als Drehachse hinaus und ist an den Enden Verlängerungsbereiche 351, 352 über die Federeinrichtungen 40a, 40b direkt mit der Mikrospiegeleinrichtung 10 versetzt zur x-Achse verbunden.

Die zweite Schwenkflügeleinrichtung 350b ist über eine Federeinrichtung 370a, 370b an gegenüberliegenden Seiten am Rahmen 1 in der xy-Ebene aufgehängt, erstreckt sich entlang der y-Achse beidseitig der Mikrospiegeleinrichtung 10 über die x-Achse als Drehachse und ist an den Enden der Verlängerungsbereiche 351', 352' über die Federeinrichtung 50a, 50b mit einem jeweiligen gewinkelten Fortsatz 70a', 70b' der Mikrospiegeleinrichtung 10 verbunden, wobei die gewinkelten Fortsätze 70a', 70b' sind entlang der y-Achse weiter zur x-Achse versetzt als die Federn 40a, 40b an die Mikrospiegeleinrichtung 10 angesetzt sind. Sie erstrecken sich entlang der y-Achse in die entgegengesetzte Richtung über die x-Achse hinaus.

Bei der fünften Ausführungsform ist kein piezoelektrischer Antrieb vorgesehen, sondern ein elektromagnetischer Antrieb, welcher eine externe Magnetfelderzeugungseinrichtung B und eine Spuleneinrichtung aufweist. Die Spuleneinrichtung weist eine erste Spule 351a auf, welche über den Rahmen 10 und die erste Schwenkflügeleinrichtung 350a geführt ist. Oberhalb der Aussparung AS‴ sind biegeschlaffe Bereiche 360 der Spuleneinrichtung 351a vorgesehen.

Die Spuleneinrichtung weist eine zweite Spule 351b auf, welche über den Rahmen 10 und die zweite Schwenkflügeleinrichtung 350b geführt ist. Oberhalb der Aussparung AS‴ sind biegeschlaffe Bereiche 360 der Spuleneinrichtung 351b vorgesehen.

Durch Anlegen von entgegengesetzten Spannungen U1 bzw. U2 an die erste und zweite Schwenkflügeleinrichtung 351a, 351b lassen sich die erste und zweite Schwenkflügeleinrichtung 350a, 350b in entgegengesetzte Richtungen entlang der z-Achse auslenken und somit eine elastische Verdrehung der Mikrospiegeleinrichtung 10 um die x-Achse erreichen.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

Obwohl die vorliegende Erfindung anhand von mikromechanischen Mikrospiegelanordnungen für Kraftfahrzeuge erläutert wurde, ist die Anwendung selbstverständlich darauf nicht beschränkt. Weitere Anwendungsbeispiele sind Projektionseinheiten für Nahfeldscanner, Partikeldetektoren, LED-Ablenkeinheiten usw.

## Patentansprüche

1. Mikromechanische Mikrospiegelanordnung mit:
einem Rahmen (1), welcher eine Aussparung (AS; AS'; AS"; AS‴) aufweist;
einer am Rahmen (1) im Bereich der Aussparung (AS; AS'; AS"; AS‴) in einer ersten Ebene (x, y) aufgehängten Mikrospiegeleinrichtung (10);
einer am Rahmen (1) aufgehängten, in den Bereich der Aussparung (AS; AS'; AS"; AS‴) hineinragenden ersten Schwenkflügeleinrichtung (2a; 201; 201'; 350a), welche an der Mikrospiegeleinrichtung (10) über eine erste Federeinrichtung (4a; 4a'; 40a, 40b) angekoppelt ist;
einer am Rahmen (1) aufgehängten, in den Bereich der Aussparung (AS; AS'; AS"; AS‴) hineinragenden zweiten Schwenkflügeleinrichtung (3a; 301; 301'; 350b), welche an der Mikrospiegeleinrichtung (10) über eine zweite Federeinrichtung (4b; 4b'; 50a, 50b) angekoppelt ist;
einer ersten Antriebseinrichtung (81a; 81a'; 81a"; 351a) zum Auslenken der ersten Schwenkflügeleinrichtung (2a; 201; 201'; 350a) entlang einer ersten Achse (z), welche senkrecht zur ersten Ebene (x, y) angeordnet ist; und
einer zweiten Antriebseinrichtung (82a; 82a'; 82a"; 351b) zum gegenphasigen Auslenken der zweiten Schwenkflügeleinrichtung (3a; 301; 301'; 350b) entlang der ersten Achse (z);
wobei die Mikrospiegeleinrichtung (10) durch das gegenphasige Auslenken der ersten Schwenkflügeleinrichtung (2a; 201; 201'; 350a) und der zweiten Schwenkflügeleinrichtung (3a; 301; 301'; 350b) um eine zweite Achse (x) elastisch aus der ersten Ebene (x, y) heraus drehbar ist; und
wobei die erste Schwenkflügeleinrichtung (2a; 201; 201') und die zweite Schwenkflügeleinrichtung (3a; 301: 301') derart gestaltet sind, dass sie sich auf einer ersten Seite der Mikrospiegeleinrichtung (10) entlang der Richtung einer im Wesentlichen senkrecht zur zweiten Achse (x) angeordneten dritten Achse (y) über die zweite Achse (x) hinaus erstrecken,
**dadurch gekennzeichnet, dass** die erste Schwenkflügeleinrichtung (201; 201') in einem ersten Bereich (100'; 100") des Rahmens (1) in der ersten Ebene (x, y) aufgehängt ist, sich gewinkelt entlang der Richtung der zweiten Achse (x) und der dritten Achse (y) erstreckt, sich entlang der Richtung der dritten Achse (y) über die zweite Achse (x) hinaus erstreckt und an ihrem Ende über die erste Federeinrichtung (4a') mit einem ersten Fortsatz (70a) der Mikrospiegeleinrichtung (10) verbunden ist, und die zweite Schwenkflügeleinrichtung (301; 301') in einem zweiten Bereich (101'; 101") des Rahmens (1), der seitlich zum ersten Bereich (100'; 100") versetzt ist, in der ersten Ebene (x, y) aufgehängt ist, sich gewinkelt entlang der Richtung der zweiten Achse (x) und der dritten Achse (y) erstreckt, sich entlang der Richtung der dritten Achse (y) über die zweite Achse (x) hinaus erstreckt und an ihrem Ende über die zweite Federeinrichtung (4b') mit einem zweiten Fortsatz (60a) der Mikrospiegeleinrichtung (10) verbunden ist, wobei der erste Fortsatz (70a) und der zweite Fortsatz (60a) in dieselbe Richtung entlang der dritten Achse (y) bezüglich der zweiten Achse (x) versetzt sind, und wobei die Mikrospiegeleinrichtung (10) auf einer der der ersten Seite gegenüberliegenden zweiten Seite über einen Torsionsbalken (250) am Rahmen (1) aufgehängt ist, wobei der erste Fortsatz (70a) geradlinig verläuft und der zweite Fortsatz (60a) gewinkelt verläuft..

2. Mikromechanische Mikrospiegelanordnung nach Anspruch 1, wobei eine erste Torsionseinrichtung (710) zum Verdrehen der ersten Schwenkflügeleinrichtung (201') um die zweite Achse (x) im ersten Bereich (100") zwischen dem ersten Bereich (100") des Rahmens (1) und der ersten Schwenkflügeleinrichtung (201') in der ersten Ebene (x, y) aufgehängt ist und eine zweite Torsionseinrichtung (720) zum Verdrehen der zweiten Schwenkflügeleinrichtung (301') um die zweite Achse (x) im zweiten Bereich (101") zwischen dem zweiten Bereich (101") des Rahmens (1) und der ersten Schwenkflügeleinrichtung (201') in der ersten Ebene (x, y) aufgehängt ist.

3. Mikromechanische Mikrospiegelanordnung nach einem der vorhergehenden Ansprüche, wobei die erste Antriebseinrichtung (81a; 81a'; 81a") und/oder die zweite Antriebseinrichtung (82a; 82a'; 82a") eine piezoelektrische Antriebseinrichtung aufweist, wobei eine piezoelektrische Leiterbahneinrichtung auf der ersten Schwenkflügeleinrichtung (2a; 201; 201') bzw. der zweiten Schwenkflügeleinrichtung (3a; 301; 301') aufgebracht ist.

4. Mikromechanische Mikrospiegelanordnung nach einem der vorhergehenden Ansprüche, wobei die erste Antriebseinrichtung (351a) und/oder die zweite Antriebseinrichtung (351b) eine elektromagnetische Antriebseinrichtung aufweist, welche eine externe Magnetfelderzeugungseinrichtung (B) und eine Spuleneinrichtung aufweist, wobei die Spuleneinrichtung auf der ersten Schwenkflügeleinrichtung (350a) bzw. der zweiten Schwenkflügeleinrichtung (350b) und dem Rahmen aufgebracht ist.

5. Mikromechanische Mikrospiegelanordnung nach einem der vorhergehenden Ansprüche, wobei eine Sensoreinrichtung (F1-F4; R1-R4) mit einer Mehrzahl von auf jeweiligen Federn (F1-F4) aufgebrachten Piezowiderständen (R1-R4), welche zwischen dem Rahmen (1) und der ersten Schwenkflügeleinrichtung (2a; 201; 201'; 350a) und dem Rahmen (1) und der zweiten Schwenkflügeleinrichtung (3a; 301; 301'; 350b) angebracht sind, zum Erfassen des elastischen Herausdrehens der Mikrospiegeleinrichtung (10) um die zweite Achse (x) aus der ersten Ebene (x, y) vorgesehen ist.

6. Mikromechanische Mikrospiegelanordnung nach einem der vorhergehenden Ansprüche, wobei auf einer Rückseite (RS) des Rahmens (1) ein erstes Kappensubstrat (150) mit einer im Bereich der Mikrospiegeleinrichtung (10) vorgesehenen Aussparung (153) und auf der Vorderseite (VS) des Rahmens (1) ein zweites Kappensubstrat (151) mit einem im Bereich der Mikrospiegeleinrichtung (10) vorgesehenen optischen Fenster (152) angeordnet ist.

## Claims

1. Micromechanical micromirror array comprising:
a frame (1) which has a cutout (AS; AS'; AS"; AS‴);
a micromirror device (10) suspended from the frame (1) in the region of the cutout (AS; AS'; AS"; AS‴) in a first plane (x, y);
a first pivoting vane device (2a; 201; 201'; 350a) suspended from the frame (1) and projecting into the region of the cutout (AS; AS'; AS"; AS‴), said first pivoting vane device being coupled to the micromirror device (10) via a first spring device (4a; 4a'; 40a, 40b) ;
a second pivoting vane device (3a; 301; 301'; 350b) suspended from the frame (1) and projecting into the region of the cutout (AS; AS'; AS"; AS‴), said second pivoting vane device being coupled to the micromirror device (10) via a second spring device (4b; 4b'; 50a, 50b) ;
a first drive device (81a; 81a'; 81a"; 351a) for deflecting the first pivoting vane device (2a; 201; 201'; 350a) along a first axis (z) which is arranged perpendicular to the first plane (x, y); and
a second drive device (82a; 82a'; 82a"; 351b) for deflecting in antiphase the second pivoting vane device (3a; 301; 301'; 350b) along the first axis (z);
wherein the micromirror device (10) can be elastically rotated out of the first plane (x, y) about a second axis (x) by the deflection in antiphase of the first pivoting vane device (2a; 201; 201'; 350a) and the second pivoting vane device (3a; 301; 301'; 350b); and
wherein the first pivoting vane device (2a; 201; 201') and the second pivoting vane device (3a; 301; 301') are designed such that they extend, on a first side of the micromirror device (10), beyond the second axis (x) along the direction of a third axis (y) arranged substantially perpendicular to the second axis (x),
**characterized in that** the first pivoting vane device (201; 201') is suspended in a first region (100'; 100") of the frame (1) in the first plane (x, y), extends at an angle along the direction of the second axis (x) and the third axis (y), extends along the direction of the third axis (y) beyond the second axis (x) and, at its end, is connected to a first projection (70a) of the micromirror device (10) via the first spring device (4a'), and the second pivoting vane device (301; 301') is suspended in a second region (101'; 101") of the frame (1), which second region is laterally offset in relation to the first region (100'; 100"), in the first plane (x, y), extends at an angle along the direction of the second axis (x) and the third axis (y), extends along the direction of the third axis (y) beyond the second axis (x) and, at its end, is connected to a second projection (60a) of the micromirror device (10) via the second spring device (4b'), wherein the first projection (70a) and the second projection (60a) are offset with respect to the second axis (x) in the same direction along the third axis (y), and wherein the micromirror device (10) is suspended from the frame (1) on a second side, situated opposite the first side, via a torsion bar (250), wherein the first projection (70a) runs in a straight line and the second projection (60a) runs at an angle.

2. Micromechanical micromirror array according to Claim 1, wherein a first torsion device (710) for rotating the first pivoting vane device (201') about the second axis (x) in the first region (100") is suspended between the first region (100") of the frame (1) and the first pivoting vane device (201') in the first plane (x, y), and a second torsion device (720) for rotating the second pivoting vane device (301') about the second axis (x) in the second region (101") is suspended between the second region (101") of the frame (1) and the first pivoting vane device (201') in the first plane (x, y).

3. Micromechanical micromirror array according to either of the preceding claims, wherein the first drive device (81a; 81a'; 81a") and/or the second drive device (82a; 82a'; 82a") have/has a piezoelectric drive device, wherein a piezoelectric conductor track device is mounted on the first pivoting vane device (2a; 201; 201') or the second pivoting vane device (3a; 301; 301').

4. Micromechanical micromirror array according to one of the preceding claims, wherein the first drive device (351a) and/or the second drive device (351b) have/has an electromagnetic drive device which has an external magnetic field generating device (B) and a coil device, wherein the coil device is mounted on the first pivoting vane device (350a) or the second pivoting vane device (350b) and the frame.

5. Micromechanical micromirror array according to one of the preceding claims, wherein a sensor device (F1-F4; R1-R4) having a plurality of piezoresistors (R1-R4) which are mounted on the respective springs (F1-F4) and are mounted between the frame (1) and the first pivoting vane device (2a; 201; 201'; 350a) and the frame (1) and the second pivoting vane device (3a; 301; 301'; 350b) is provided for sensing elastic rotation of the micromirror device (10) about the second axis (x) out of the first plane (x, y).

6. Micromechanical micromirror array according to one of the preceding claims, wherein a first cap substrate (150) with a cutout (153) provided in the region of the micromirror device (10) is arranged on a rear side (RS) of the frame (1) and a second cap substrate (151) with an optical window (152) provided in the region of the micromirror device (10) is arranged on the front side (VS) of the frame (1).

## Revendications

1. Agencement micromécanique de micromiroir, comprenant :
un cadre (1) qui présente un évidement (AS ; AS' ; AS" ; AS‴) ;
un dispositif de micromiroir (10) suspendu au cadre (1) dans la zone de l'évidement (AS ; AS' ; AS" ; AS"') dans un premier plan (x, y) ;
un premier dispositif de panneau pivotant (2a ; 201 ; 201' ; 350a) suspendu au cadre (1), faisant saillie dans la zone de l'évidement (AS ; AS' ; AS" ; AS"'), et qui est accouplé au dispositif de micromiroir (10) par l'intermédiaire d'un premier dispositif faisant ressort (4a ; 4a' ; 40a, 40b) ;
un deuxième dispositif de panneau pivotant (3a ; 301 ; 301' ; 350b) suspendu au cadre (1), faisant saillie dans la zone de l'évidement (AS ; AS' ; AS" ; AS"'), et qui est accouplé au dispositif de micromiroir (10) par l'intermédiaire d'un deuxième dispositif faisant ressort (4b ; 4b' ; 50a, 50b) ;
un premier dispositif d'entraînement (81a ; 81a' ; 81a" ; 351a) pour dévier le premier dispositif de panneau pivotant (2a ; 201 ; 201' ; 350a) le long d'un premier axe (z) qui est disposé perpendiculairement au premier plan (x, y) ; et
un deuxième dispositif d'entraînement (82a ; 82a' ; 82a" ; 351b) pour dévier en opposition de phase le deuxième dispositif de panneau pivotant (3a ; 301 ; 301' ; 350b) le long du premier axe (z) ;
dans lequel le dispositif de micromiroir (10) peut subir une rotation élastique hors du premier plan (x, y) autour d'un deuxième axe (x) par la déviation en opposition de phase du premier dispositif de panneau pivotant (2a ; 201 ; 201' ; 350a) et du deuxième dispositif de panneau pivotant (3a ; 301 ; 301' ; 350b) ; et
dans lequel le premier dispositif de panneau pivotant (2a ; 201 ; 201') et le deuxième dispositif de panneau pivotant (3a ; 301 ; 301') sont configurés de telle sorte qu'ils s'étendent au-delà du deuxième axe (x) sur un premier côté du dispositif de micromiroir (10) le long de la direction d'un troisième axe (y) disposé de manière substantiellement perpendiculaire au deuxième axe (x),
**caractérisé en ce que** le premier dispositif de panneau pivotant (201 ; 201') est suspendu dans une première zone (100' ; 100") du cadre (1) dans le premier plan (x, y), s'étend de manière coudée le long de la direction du deuxième axe (x) et du troisième axe (y), s'étend le long de la direction du troisième axe (y) au-delà du deuxième axe (x), et est relié à son extrémité par l'intermédiaire du premier dispositif faisant ressort (4a') à un premier prolongement (70a) du dispositif de micromiroir (10), et le deuxième dispositif de panneau pivotant (301 ; 301') est suspendu dans le premier plan (x, y) dans une deuxième zone (101' ; 101") du cadre (1) qui est décalée latéralement par rapport à la première zone (100' ; 100"), s'étend de manière coudée le long de la direction du deuxième axe (x) et du troisième axe (y), s'étend le long de la direction du troisième axe (y) au-delà du deuxième axe (x), et est relié à son extrémité par l'intermédiaire du deuxième dispositif faisant ressort (4b') à un deuxième prolongement (60a) du dispositif de micromiroir (10), dans lequel le premier prolongement (70a) et le deuxième prolongement (60a) sont décalés par rapport au deuxième axe (x) dans la même direction le long du troisième axe (y), et dans lequel le dispositif de micromiroir (10) est suspendu au cadre (1) par l'intermédiaire d'une barre de torsion (250) sur un deuxième côté opposé au premier côté, dans lequel le premier prolongement (70a) s'étend de manière rectiligne et le deuxième prolongement (60a) s'étend de manière coudée.

2. Agencement micromécanique de micromiroir selon la revendication 1, dans lequel un premier dispositif de torsion (710) permettant de faire tourner le premier dispositif de panneau pivotant (201') autour du deuxième axe (x) dans la première zone (100") est suspendu entre la première zone (100") du cadre (1) et le premier dispositif de panneau pivotant (201') dans le premier plan (x, y), et un deuxième dispositif de torsion (720) permettant de faire tourner le deuxième dispositif de panneau pivotant (301') autour du deuxième axe (x) dans la deuxième zone (101") est suspendu entre la deuxième zone (101") du cadre (1) et le premier dispositif de panneau pivotant (201') dans le premier plan (x, y) .

3. Agencement micromécanique de micromiroir selon l'une quelconque des revendications précédentes, dans lequel le premier dispositif d'entraînement (81a ; 81a' ; 81a") et/ou le deuxième dispositif d'entraînement (82a ; 82a' ; 82a") présentent un dispositif d'entraînement piézoélectrique, dans lequel un dispositif de piste conductrice piézoélectrique est appliqué sur le premier dispositif de panneau pivotant (2a ; 201 ; 201') ou le deuxième dispositif de panneau pivotant (3a ; 301 ; 301') respectivement.

4. Agencement micromécanique de micromiroir selon l'une quelconque des revendications précédentes, dans lequel le premier dispositif d'entraînement (351a) et/ou le deuxième dispositif d'entraînement (351b) présentent un dispositif d'entraînement électromagnétique qui présente un dispositif de génération de champ magnétique externe (B) et un dispositif de bobine, dans lequel le dispositif de bobine est appliqué sur le premier dispositif de panneau pivotant (350a) ou sur le deuxième dispositif de panneau pivotant (350b) respectivement et le cadre.

5. Agencement micromécanique de micromiroir selon l'une quelconque des revendications précédentes, dans lequel est prévu un dispositif capteur (F1 à F4 ; R1 à R4) pourvu d'une pluralité de résistances piézoélectriques (R1 à R4) appliquées sur des ressorts (F1 à F4) respectifs et qui sont installées entre le cadre (1) et le premier dispositif de panneau pivotant (2a ; 201 ; 201' ; 350a) et entre le cadre (1) et le deuxième dispositif de panneau pivotant (3a ; 301 ; 301' ; 350b), pour détecter la rotation élastique du dispositif de micromiroir (10) autour du deuxième axe (x) hors du premier plan (x, y).

6. Agencement micromécanique de micromiroir selon l'une quelconque des revendications précédentes, dans lequel un premier substrat de recouvrement (150) pourvu d'un évidement (153) prévu dans la zone du dispositif de micromiroir (10) est disposé sur une face arrière (RS) du cadre (1), et un deuxième substrat de recouvrement (151) pourvu d'une fenêtre optique (152) prévue dans la zone du dispositif de micromiroir (10) est disposé sur la face avant (VS) du cadre (1).
